(19) Europäisches Patentamt
European Patent Office
Office européen des brevets

(11) **EP 4 783 380 A1**

(12) **EUROPEAN PATENT APPLICATION**

(43) Date of publication:
**29.07.2026 Bulletin 2026/31**

(21) Application number: 25223311.9

(22) Date of filing: **15.12.2025**

(51) International Patent Classification (IPC):
**H01S 5/183** (2006.01)

(52) Cooperative Patent Classification (CPC):
**H01S 5/18308; H01S 5/18338;** H01S 5/18391;
H01S 2301/163; H01S 2301/166; H01S 2301/203

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **24.01.2025 US 202563833908 P
25.01.2025 US 202563749559 P
29.10.2025 US 202519372850**

(71) Applicant: **II-VI Delaware, Inc.
Wilmington, DE 19890 (US)**

(72) Inventors:
• **GRAZIANO, Giacomo**
**Wilmington, DE 19890 (US)**
• **TIRELLI, Stefano**
**Wilmington, DE 19890 (US)**
• **ZIBIK, Evgeny**
**Wilmington, DE 19890 (US)**
• **MAINEULT, Wilfried**
**Wilmington, DE 19890 (US)**

(74) Representative: **Schmidt, Christian
ZSP Patentanwälte PartG mbB
Hansastraße 32
80686 München (DE)**

(54) **RING APERTURE VERTICAL-CAVITY SURFACE-EMITTING LASER (VCSEL) DEVICES FOR MODE CONTROL**

(57) Systems and methods are provided for ring aperture vertical-cavity surface-emitting laser (VCSEL) devices for mode control. A VCSEL is provided where the optical mode and the current confinement is defined by patterning the same layer of the resonant cavity within the epitaxial layer with a ring-shaped aperture. The ring width may be small enough to be single mode along the radius. The two concentric boundaries forming the ring aperture may be of any arbitrary shape as long as the width is small enough to be single mode along the radial direction.

**EP 4 783 380 A1**

## Description

CLAIM OF PRIORITY

This patent application claims priority to and claims benefit from United States Provisional Patent Application Serial No. 63/833,908, filed on January 24, 2025, and United States Provisional Patent Application Serial No. 63/749,559, filed on January 25, 2025. Each of the above identified applications is hereby incorporated herein by reference in its entirety.

TECHNICAL FIELD

Aspects of the present disclosure relate to optical communication based solutions. More specifically, certain implementations of the present disclosure relate to methods and systems for implementing and utilizing ring aperture vertical-cavity surface-emitting laser (VCSEL) devices for mode control.

BACKGROUND

Limitations and disadvantages of conventional diffraction gratings will become apparent to one of skill in the art, through comparison of such systems with some aspects of the present disclosure as set forth in the remainder of the present application with reference to the drawings.

BRIEF SUMMARY

System and methods are provided for ring aperture vertical-cavity surface-emitting laser (VCSEL) devices for mode control, substantially as shown in and/or described in connection with at least one of the figures, as set forth more completely in the claims.

These and other advantages, aspects and novel features of the present disclosure, as well as details of an illustrated embodiment thereof, will be more fully understood from the following description and drawings.

BRIEF DESCRIPTION OF THE DRAWINGS

Fig. 1 illustrates an example vertical-cavity surface-emitting laser (VCSEL).

Fig. 2 illustrates an example circular aperture and an example ring aperture and corresponding current and fundamental mode intensity profiles thereof.

Fig. 3 illustrates an example VCSEL with ring aperture and an example process for fabricating the VCSEL.

Fig. 4 illustrates an example ring aperture and example optical modes thereof.

Fig. 5 illustrates example spectrums of a circular aperture and a ring aperture.

Fig. 6 illustrates an example circular aperture and an example ring aperture and corresponding excited optical modes thereof.

Fig. 7 illustrates different example ring apertures with different shapes.

Fig. 8 illustrates different example ring apertures with different surface features.

Fig. 9 illustrates different example ring apertures with different surface etching.

Fig. 10 illustrates an example aperture with multiple concentric rings.

DETAILED DESCRIPTION

Vertical cavity surface-emitting lasers (VCSELs) are optical devices that are typically used as laser sources in various implementations, such as in optical transceivers which may be used in optical networks or systems. VCSELs typically employ semiconductor laser diode based structures configured to emit laser beams perpendicularly from a top surface of the structure (either top-emitting-that is, external to the structure, or bottom-emitting-that is, within or into the structure).

Various designs and/or structures may be used in implementing VCSELs, each employing distinct mechanisms to achieve current and light confinement. Commonly, current confinement may be achieved with a lateral oxidation process, which implements current and light confinement. Other methods used to confine current and light include ion implantation and etching, and/or by implementing a photonic-crystal structure. Another possible solution to implement both current and light confinement is growing the epitaxial structure forming the VCSEL in two steps, with the first one terminating the growth with a tunnel junction, which is then patterned by lithography and etching. A second epitaxial growth (overgrowth) process then may complete the epitaxial structure. Finally, the VCSEL is implemented by a standard fabrication process.

Compared to other embodiments, buried tunnel junction (TJ) VCSELs generally display a strong index confinement due to the step introduced by the TJ etching. This affects the modes properties excited by the structure which results in higher spectrum width.

Solutions in accordance with the present disclosure are directed to VCSELs where angularly degenerate modes are excited making the mode frequency spacing narrower and thermal resistance lower. This may be done by utilizing ring-shaped apertures. In this regard, as used herein, the term "ring" or "ring-shaped" refers to an aperture defined by the space between two concentric, non-intersecting boundaries of arbitrary shapes. For instance, if the boundaries are concentric circles, the ring aperture takes the form of an annulus.

Use of ring-shaped apertures may have many benefits and/or advantages. In this regard, for the same aperture area, the heat dissipated inside the cavity is spread over a wider area, reducing the junction operating temperature. Implementations based on the present disclosure may operate single mode through periodic patterning of the ring's width or specific patterning of surface relief feature. The combination of ring aperture patterning and mode filter allows to scale the aperture area and therefore power keeping the possibility to still get single mode emission, selecting one mode with arbitrary azimuthal order. Accordingly, with use of ring apertures in embodiments based on the present disclosure, it may be possible to achieve coherent, single-mode emission while maintaining the benefits of a larger aperture. Example embodiments and details related thereto are described in more detail below.

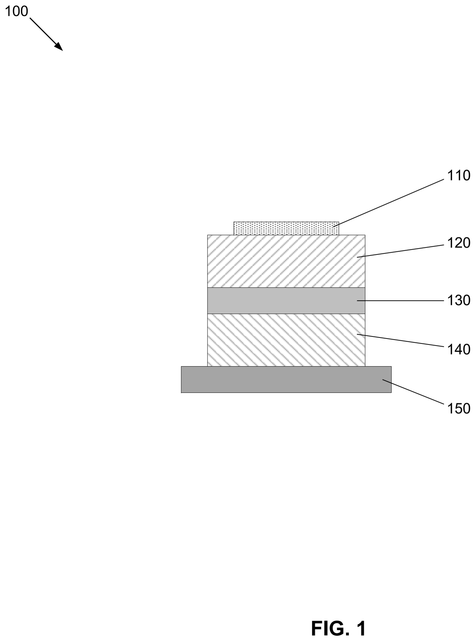

Fig. 1 illustrates an example vertical-cavity surface-emitting laser (VCSEL). Shown in Fig. 1 is a VCSEL 100 (or portion thereof).

The VCSEL 100 may comprise a semiconductor laser diode based structure, configured to emit laser beams perpendicularly from a top surface of the structure (either top-emitting-that is, external to the structure, or bottom-emitting-that is, within or into the structure). VCSELs are commonly used as light (e.g., laser) sources, particularly in such implementations as transceivers (e.g., optical transceivers used in datacenters). Conventionally, VCSELs are driven using one or both of direct current ($I_{dc}$) and alternating current ($I_{ac}$).

Various designs and/or structures may be used in VCSELs. For example, the VCSEL 100 may utilize a distributed Bragg reflector (DBR) based structure. An example DBR-based structure is illustrated in Fig. 1. In this regard, as shown in Fig. 1, the VCSEL 100 comprises a contact 110, top DBR mirror (layer) 120, an active region 130, a bottom DBR mirror (layer) 140, and a substrate layer 150. In this regard, as used herein the term "layer" does necessarily mean a single layer; rather, some of the structures described herein as layer (e.g., DBRs and active regions) may comprise stacks of layers rather than a single layer. The DBR mirrors (layers) 120 and 140 are disposed parallel to the top surface of the VCSEL 100, with the active region 130 disposed between the DBR mirrors 120 and 140. The active region 130 may comprise one or more quantum wells, for the laser light generation. In this regard, the active region 130 may comprise a multiple-quantum-well (MQW) layer. The active region 130 may function as a gain medium, sandwiched between the two DBR mirrors. The bottom DBR mirror 140 may be disposed on top of the substrate layer 150, which in some instances, may be disposed on top of a heat sink layer (not shown). The contact 110 is disposed on top of the top DBR mirror 120. A bottom contact (not shown) may also be incorporated into the structure, such as bottom side of the VCSEL 110 (e.g., on the substrate layer 150). The contacts may comprise, e.g., metal material or the like. In this regard, during operation of the VCSEL 110, with the driving current(s) flowing through the contract 110 (and the bottom contact, where one is used).

In some instances, the DBR mirrors 120 and 140 may comprise layers with alternating high and low refractive index (RI) based material. The thickness of each layer may be set to yield high reflectivity. Use of high reflectivity may be used to balance short axial length of the gain region. In some instances, p-type and n-type regions may be embedded between the DBR mirrors 120 and 140, forming a diode junction. This may involve more complex semiconductor processing to ensure electrical contact to the active layer/region, but may eliminate electrical power loss in the DBR structure.

In accordance with the present disclosure, improved VCSELs may be implemented, having improved performance, particularly with respect to the mode control. In particular, this may be done by incorporating adjustments and/or additions to the structure of the VCSELs, which may yield improved performance without adding too much cost and/or complexity. This is described in more detail below.

In this regard, mode control in VCSELs is essential for optimizing performance in various applications. In optical communication, single-mode or low-order multi-mode operation may be preferred, as opposed to a broad, multi-mode emission, which may introduce noise and chromatic dispersion in the fiber. Narrow linewidth or single-mode VCSELs may be particularly beneficial in this context, offering a narrow emission spectrum and stable output that helps minimize signal distortion after propagation over long distances. Mode control may be an asset for high power VCSELs, particularly in applications that require both high output power and single-mode operation. In these cases, achieving single-mode operation at high power levels presents challenges caused by thermal effects and mode instability.

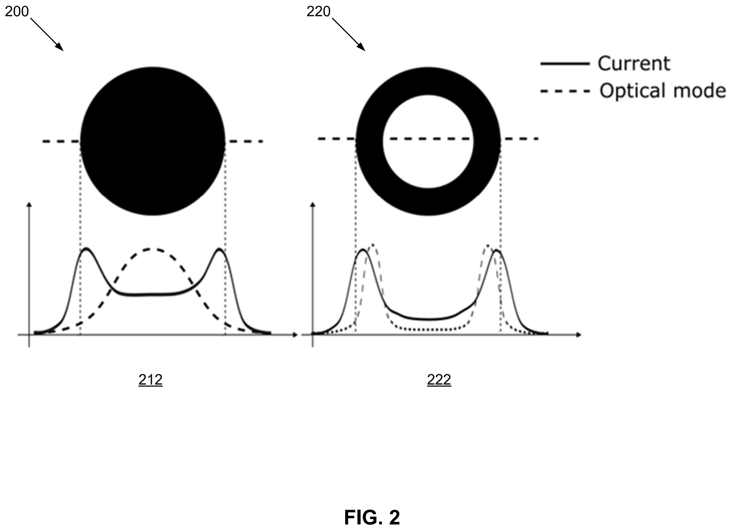

Additionally, current-pumped VCSELs are often affected by a non-uniform current density within the cavity. The phenomenon known as current crowding causes the current density to be higher at the edge of the aperture. This is illustrated and described in more detail with respect to Fig. 2. This non-uniformity reduces the overlap between the optical mode and the pumped active region area, ultimately limiting the performance of the device. In the case of single-mode VCSELs the selected mode is usually the fundamental Gaussian mode, which due to the localization of peak intensity in the center of the aperture, may further restrict the efficiency of the optical device.

Solutions based on the present disclosure may address limitations and/or issues associated in conventional VCSELs, particularly by use of modified apertures that yield improved performance with respect to mode control. In various embodiments based on the present disclosure VCSELs may incorporate ring-shaped lithographic aperture based structures, to provide both current and light confinement, where the current and light confining layer is patterned such that the structure is single mode along the width of the ring aperture. The refractive index contrast introduced by the confining layer allows for promoting modes that share the same spatial profile along the radius distribution, but whose order may be only defined by their angular intensity distribution. This is illustrated and described in more detail with respect to Fig. 2.

Fig. 2 illustrates an example circular aperture and an example ring aperture and corresponding current and fundamental mode intensity profiles thereof. Shown in Fig. 2 are a circular aperture (that is, conventional aperture) 200 and a ring aperture 220.

In this regard, the ring aperture 220 is implemented in accordance with the present disclosure. Also shown in Fig. 2 are graphs 212 and 222 illustrating the current and fundamental mode intensity profile for, respectively, each of the circular aperture and the ring aperture 220. As noted above, VCSELs incorporating conventional designs, such as the circular aperture 200, may have some limitations and/or issues with respect to mode control.

For example, as illustrated in graph 212, current-pumped VCSEL incorporating conventional apertures (e.g., the circular aperture 200) may be affected by a non-uniform current density within the cavity of the VCSEL, such as due to current crowding that causes the current density to be higher at the edge of the aperture, as shown in graph 200. This non-uniformity reduces the overlap between the optical mode and the pumped active region area, and in instances where the selected mode is a fundamental Gaussian mode, this may result in the localization of peak intensity in the center of the aperture, as illustrated in graph 212, which may further restrict the efficiency of the VCSEL.

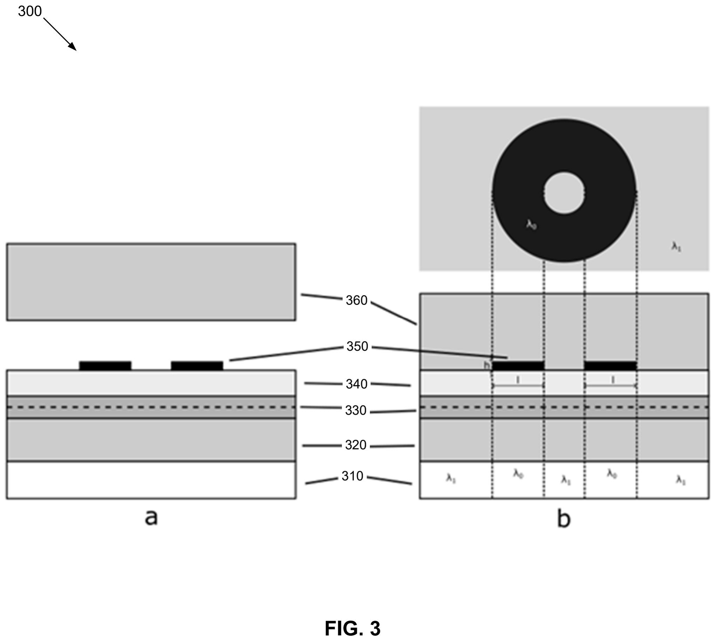

In implementations based on the present disclosure, such as in VCSELs incorporating the ring aperture 220, mode control and current confinement may be addressed in a combined way. In this regard, a mode-selection and current confining layer may be introduced into the VCSEL. For example, this may be done during the growth of the epitaxial layers which include, e.g., bottom DBR, cavity, active region and concluding with top layer (e.g., tunnel junction (TJ) layer). The top layer is then patterned, such as using lithographic techniques, then the rest of the epitaxial growth is carried out, and the VCSEL is finally fabricated through a fabrication process. An example VCSEL implemented based on the process is illustrated and described in more detail with respect to Fig. 3.

Accordingly, in implementations based on the present disclosure it may be possible to promote modes with a frequency spacing which is independent from the refractive index step introduced by the lithographic aperture and depends only on the geometrical shape of the patterned layer making the design more robust and controllable. In instances where the device is multi-mode, the spectrum width may be reduced improving the transmission through optical fiber for data transmission.

Further, embodiments based on the present disclosure may address mode control and optical mode overlap, such as through a ring patterned layer that confines light and current simultaneously. Shaping the current confinement layer as explained herein allows for modifying the current injection to improve overlap with the optical mode excited by the structure. This is illustrated in graph 222 corresponding to the ring aperture 220. Also, the heat generated in the device may dissipate on a wider area, at the same time and for the same emission area, thus improving the thermal resistance of the full structure. Better thermal properties and better efficiency may also improve modulation bandwidth and reliability of the VCSEL.

In addition, periodic width variation may allow use of the transversal component of the light to promote single mode emission, without affecting the losses of the structure. Alternatively, the periodic patterning of a surface relief may also be used to select a specific high order mode. These two approaches may be combined together to stabilize the single mode operating range. Accordingly, it would be possible to select one mode with arbitrary angular order and not the fundamental gaussian mode as it happens for surface relief mode filters in circular or elliptical apertures. This may allow for increasing the power scaling up the area of the aperture while keeping the emission single mode, thus removing the limitation imposed by the selection of the fundamental mode.

Fig. 3 illustrates an example VCSEL with ring aperture and an example process for fabricating the VCSEL. Shown in Fig. 3 is VCSEL 300.

The VCSEL 300 may be substantially similar to the VCSEL 100 of Fig. 1, and may operate in substantially similar manner. The VCSEL 300 may be implemented as a GaAs-based VCSEL. However, the VCSEL 300 may incorporate a ring aperture implemented in accordance with the present disclosure.

In this regard, in accordance with the present disclosure, a specific shape of cavity structuring may be used to achieve or promote angularly degenerate mode selection in optical devices (e.g., VCSELs). The VCSEL 300 represents a possible implementation of the resulting device. The technique requires an "overgrowth" process, where the epitaxial layer(s) used to fabricate the VCSEL may be grown in two steps by a suitable epitaxial growth technique, such as metal organic chemical vapor deposition (MOCVD). In this regard, as noted above, as used herein the term "layer" does necessarily mean a single layer; rather, some of the structures described herein as layer (e.g., DBRs and active regions) may comprise stacks of layers rather than a single layer.

The epitaxial structures grown in these two steps are shown in the VCSEL 300 as illustrated in Fig. 3. In this regard, the VCSEL 300 may comprise six (6) layers: 310, 320, 330, 340, 350, and 360, each of which is described in more detail below. For simplicity it is assumed that VCSEL 300 exhibits central symmetry, as shown in Fig. 3. In particular, shown in Fig. 3 (reference a) is a schematic representation of the epitaxial layers grown in the first step (layers 310-350) and the second step (top layer 360). Also shown in Fig. 3 (reference b) is a cross-section of the complete VCSEL structure (contacts excluded), assuming central symmetry, where *l* represents the width of the ring aperture, *h* is the amount height difference in the cavity. The dotted line schematically represents the different regions, where the resonant wavelengths *λ0* and *λ1* may be different. Also shown is a top-view of the patterned the layer 350, with the regions of *λ0* and *λ1* highlighted.

The layer 310 represents the substrate onto which the first epitaxial growth starts. The layer 320 represents the bottom Distributed Bragg-Reflection (DBR) mirror, and is grown on top of the layer 310, followed by the layer 330, which represents a cavity which contains an active region schematically represented by a dashed line in Fig. 3. The layer 340 completes the cavity (the layer 330) and may contain a portion of the top distributed Bragg-reflection (DBR) mirror. The layer 340 may comprise the same material as the cavity (the layer 330) and/or may comprise material similar to the subsequent top layer 360. The first epitaxial growth is then ended with the layer 350, which is a conductive layer, thus allowing passing of the current into the device, such as from the top contact, which is realized within or on top of the top layer 360.

In the second step the layer 350 is patterned to create a protuberance that will define the refractive index confinement and confine the current. This feature may be obtained by a lithographic technique or process that involves masking the epitaxial layer with a suitable mask (e.g. resist), exposing it and developing part of it. The exposed areas are then etched for a total depth *h* by a standard wet or dry etching technique. The remaining mask is then removed, and the surface is cleaned and prepared for the subsequent epitaxial growth process (overgrowth). The top layer 360 is a section that form or complete the top DBR mirror, depending on the definition of the layer 340. As illustrated in Fig. 3, the top layer 360 is grown and/or formed as a uniform layer and is not patterned as with the layer 350. In this regard, the layer 360 may be either fully epitaxially grown, or may be first epitaxially grown (e.g., partially) and then completed with deposited material. Nonetheless, the full layer 360 still comprises of DBR pairs in both approaches.

In this regard, as used herein, "uniform layer" means that the layer is at least uniform in thickness. As such, while having uniform thickness, the top layer 360 may not be uniform in composition, and thus may be composed of multiple layers (e.g., constituting DBR pairs). Nonetheless, in some instances the top layer may also be uniform in composition-that is, both in thickness and composition.

This may be achieved and possible-that is, forming a uniform layer on top of a patterned layer/structure-when forming a VCSEL (e.g., the VCSEL 300) using the process described herein (e.g., the "overgrowth" process), whereas this may not be possible when using other processes such as oxide VCSEL based approaches. In this regard, when using those other processes, the top layer (e.g., one similar to the top layer 360) would have a same shape as a patterned layer-e.g., when the patterned layer has a ring shape, the top layer would be formed with a similar shape, and thus will have a hole in the center of the ring and the structure is processed further. Use of oxide VCSEL based approaches may also prevent or prohibit use of lithographic techniques in patterning the layer 350 (e.g., in shape of ring). Once the epitaxial growth is complete, the rest of the VCSEL fabrication follows. The complete epitaxial layer structure after the two growths is shown in Fig. 3 (reference b).

The layer 350 may be designed and/or implemented such that it has high electrical conductivity, and its patterning step creates regions where current flow is limited, by creating blocking barriers at the interfaces between the layer 340 and the top layer 360. Light may be emitted and collected both from top and bottom side of the full structure.

The patterning of the layer 350 may produce two groups of regions: the main cavity and the outer cavity, where the resonant wavelength will be different and equal to $\lambda_0$ and $\lambda_1$, respectively, and current may flow only through the former. The difference between these wavelengths defines the effective index (RI) confinement of the structure and determines the optical mode. In particular, the effective index step ($\Delta n = n_0 - n_1$, where $n_0$ is the effective refractive index related to $\lambda_0$ and $n_1$ related to $\lambda_1$) is given by the formula:

$$\frac{\Delta n}{n_0} = \frac{\lambda_1 - \lambda_0}{\lambda_0},$$

where $\Delta n$, defines the supported optical modes with a given geometry, e.g. the maximum size for the guiding pattern to have single mode operation. In accordance with the present disclosure, the layer 350 may be patterned with a ring shape. The width of the ring *l* is narrow enough to allow the structure to support a single mode in the radial direction. As such, the final structure may support multiple modes, but all these modes share the same spatial profile along the radial direction. In this regard, forming a VCSEL (e.g., the VCSEL 300) using the process described herein (e.g., the "overgrowth" process) may allow $\Delta n$ to have values higher than 1% (e.g., 2%), which may not be possible to achieve when using other approaches, such as oxide aperture based techniques.

Shown in Fig. 3 (reference b) are the two vertical regions defined by the etching step of the fabrication process, where the middle one has a width $l$. Considering the vertical waveguide formed by the three adjacent regions $\lambda_0$, $\lambda_1$, and $\lambda_0$, the maximum width $l$ of the ring aperture, to have single-mode behavior in the radial direction, may be computed. In this regard, the maximum value may be estimated (e.g., following standard consideration about waveguides) by imposing a maximum value for the $V$ number of the equivalent step index waveguide, given by the formula:

$$ V = \frac{\pi}{\lambda} l \sqrt{n_0^2 - n_1^2} < 2.405 $$

For example, for a VCSEL with $\lambda$ = 850 nm, the value of width $l$ is about 1 $\mu$m.

In the situation depicted in Fig. 3 (reference b) the index contrast increases with higher values of $h$. Therefore, a higher $h$ is beneficial when a stronger confinement of the light is needed or desired, promoting smaller mode volumes and affecting the overlap with the current distribution.

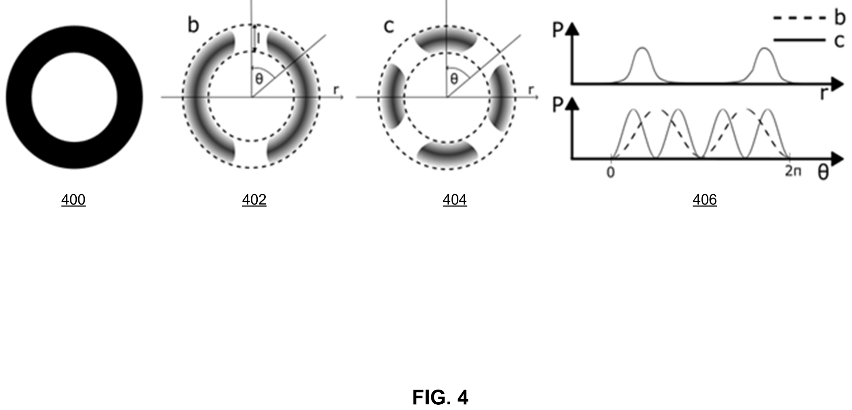

Compared to other types of VCSEL (e.g., VCSELs incorporating conventional apertures), in a VCSEL designed and/or implemented based on the present disclosure (e.g., incorporating aperture with ring-shaped design) the excited optical modes share the same radial distribution which is imposed by the specific patterning of the layer 350, but may differ by the angular distribution of the light intensity. This is illustrated and described in more detail with respect to Fig. 4.

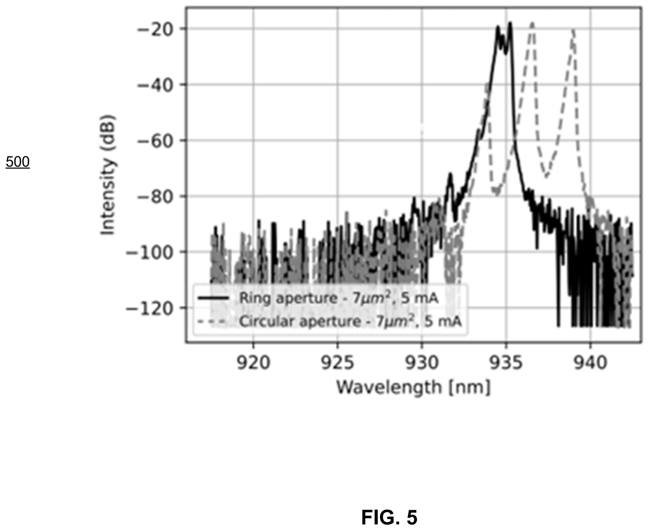

Further, it may be possible to reduce the interdependence of the refractive index step introduced by the protuberance in the layer 350 with the spectrum width and the frequency separation of the optical modes emitted by the VCSEL. This is illustrated and described in more detail with respect to Fig. 5.

Further, use of lithographic techniques in patterning the layer 350 allows for achieving smaller dimensions (e.g., as small as 200nm for the internal radius of the ring) than possible when using other techniques, such as with oxide VCSEL based techniques.

Fig. 4 illustrates an example ring aperture and example optical modes thereof. Shown in Fig. 4 is a ring aperture 400, which is implemented in accordance with the present disclosure.

The ring aperture 400 has ring's width $l$. Also shown in Fig. 4 are schematics representing radial and angular intensity distribution of two excited modes 402 and 404 of the ring aperture 400. As illustrated in Fig. 4, the two excited modes 402 and 404 of the ring aperture 400 share the same radial distribution but differ in their angular distribution, with the excited mode 402 having 2 nodes whereas the excited mode 404 has 4 nodes. The angular distribution of the two excited modes 402 and 404 is illustrated more clearly in graph 406. When the modes are expanded into radial and angular components, the aperture structure supports only one mode in the radial component, while being multimodal in the angular component.

Fig. 5 illustrates example spectrums of a circular aperture and a ring aperture. Shown in Fig. 5 is a graph 500 illustrating spectrum of a circular aperture (that is, conventional aperture) and ring aperture implemented in accordance with the present disclosure. The apertures have same aperture area (e.g., 7 $\mu$m$^2$) and are operated under same conditions (e.g., at 5 mA).

The graph 500 comprises data representing spectrum characteristics of the two apertures. In this regard, the graph 500 comprises two plots corresponding to the two apertures, each of the plots comprising data points representing intensity level in decibels (dB) (y-axis) as a function of wavelength of the optical signal(s) being emitted.

As illustrated in graph 500, the spectrum for the ring aperture is much narrower, due to different set of excited modes. In this regard, use of apertures implemented in accordance with the present disclosure (e.g., ring aperture as described with respect to Figs. 3 and 4) allows for reducing the interdependence of the refractive index step introduced by, e.g., the protuberance in layer 350, with the spectrum width and the frequency separation of the optical modes emitted by the VCSEL incorporating the ring aperture.

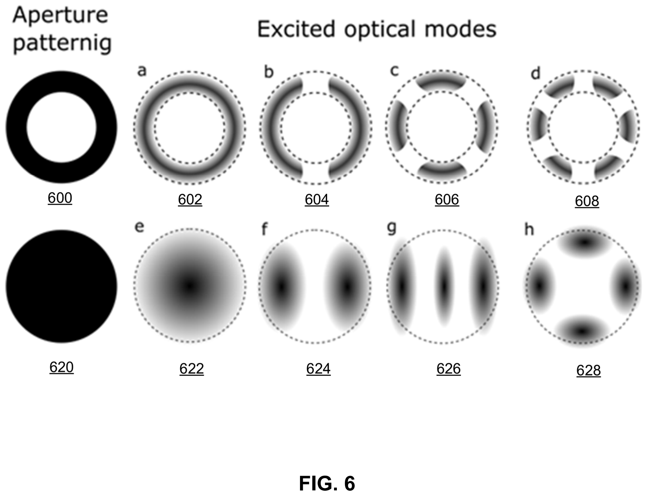

Fig. 6 illustrates an example circular aperture and an example ring aperture and corresponding excited optical modes thereof. Shown in Fig. 6 are apertures 600 and 620.

The aperture 600 comprises a circular aperture-that is, a conventional aperture-whereas the aperture 620 comprises a ring aperture, implemented in accordance with the present disclosure. Also shown in Fig. 6 are excited optical modes 602, 604, 606, and 608 for the circular aperture 600, and corresponding excited optical modes 622, 624, 626, and 628 for the ring aperture 620. In this regard, the dashed lines in the excited optical modes represent the edge of the high refractive index region. The excited optical modes 602, 604, 606, and 608 represent the 1$^{st}$, 2$^{nd}$, 3$^{rd}$ and 4$^{th}$ excited modes, respectively. The excited optical modes 622, 624, 626, and 628 represent the transverse electromagnetic (TEM) modes TEM$_{00}$, TEM$_{10}$, TEM$_{02}$, TEM$_{11}$.

In this regard, the ring shape, which leads to the suppression of the main gaussian mode, may be easily obtained, e.g., by lithographic definition of the layer 350, which then defines current and index confinement. With a standard oxidation process, it is not possible to define a ring-shape aperture, therefore circular apertures are commonly used. Shown in Fig. 6 are example optical modes that are excited with ring apertures compared to those excited in a conventional circular (or elliptical aperture). In the case of a ring aperture, the modes share the same radial profile but differ in the angular intensity distribution. On the other hand, in the case of conventional circular aperture, the modes have a different number of nodes and not all of them are cylindrically symmetric. This results in much larger energy and wavelength splitting between those modes and hence much broader spectral width compared to the ring aperture, as illustrated in and described with respect to Fig. 5, above.

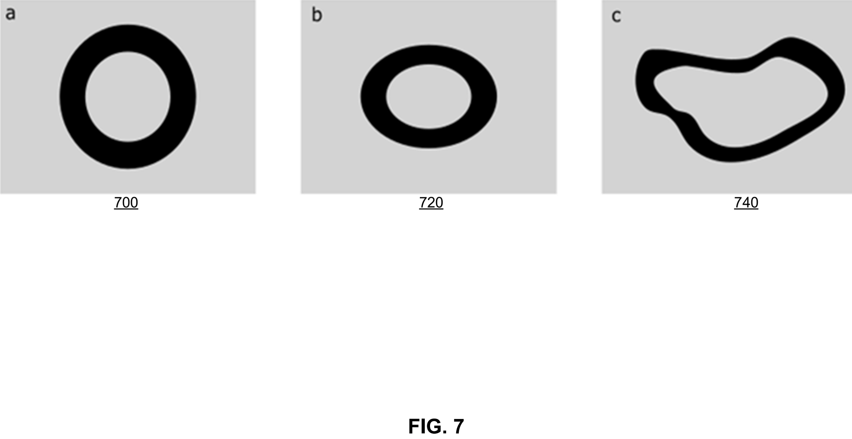

Fig. 7 illustrates different example ring apertures with different shapes. Shown in Fig. 7 are apertures 700, 720, and 740. The aperture 700 is a circular ring aperture, the aperture 720 is an elliptical ring aperture, and the aperture 740 is an arbitrary shape ring aperture.

In this regard, while in various embodiments described herein the proposed aperture has a uniform circular ring shape, the disclosure is not limited to such design or shape, and instead any suitable shape may be used as long as the resultant ring aperture would meet the required performance criteria. In particular, the shape of the aperture (e.g., the shape of top layer 360 after etching) is not limited to circular ring shapes, and any ring shape may be used as long as, e.g., the width of the ring is sufficient to guarantee single mode radially. In this regard, the lithographic aperture process, as described herein, may allow the ring aperture to have arbitrary shape and the width may be varied along the ring.

Examples of different shapes that may be implemented while keeping a ring pattern and single-mode emission are shown in Fig. 7. In this regard, as noted above, whereas the aperture 700 has a circular ring shape, the aperture 720 has an elliptical ring shape, and the aperture 740 has an arbitrary shape.

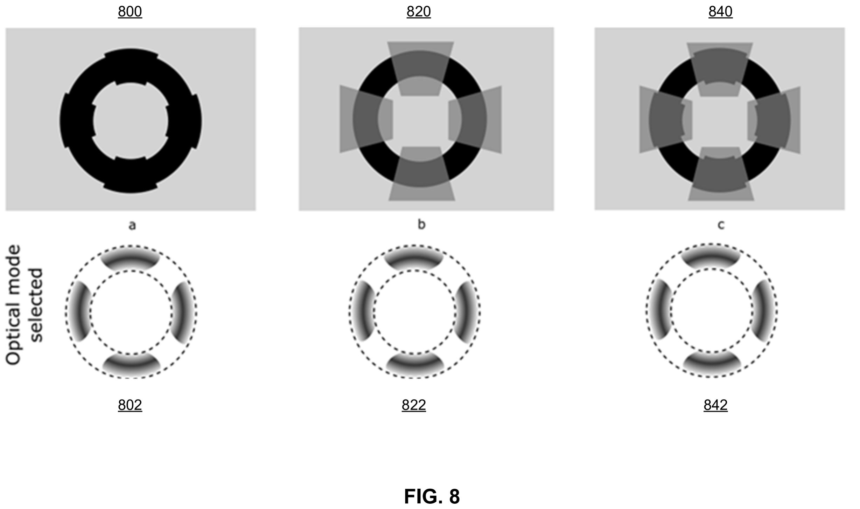

Fig. 8 illustrates different example ring apertures with different surface features. Shown in Fig. 8 are an aperture structure 800, an aperture structure 820, and an aperture structure 840.

Illustrated in Fig. 8 is the use of periodically patterned width and/or periodic surface relief in ring apertures implemented in accordance with the present disclosure. As shown in Fig. 8, the aperture structure 800 comprises a ring aperture with periodically patterned aperture width, the aperture structure 820 comprises a ring aperture with periodic surface relief, and the aperture structure 840 comprises a ring aperture with periodically patterned aperture width and periodic surface relief. Each of these three aperture structures is designed to select the same optical mode illustrated in the bottom (below the structure). In other words, an optical mode- e.g., one of the modes shown-may be activated by selecting and/or using the corresponding patterning in the layer 350.

In this regard, an additional design consideration that may be leveraged in designing ring apertures in embodiments based on the present disclosure is selecting one specific order for the angular mode beside the fundamental one, while keeping single mode emission. Several designs may be implemented to achieve such angular mode selection. One such design, illustrated in the aperture structure 800, is to periodically pattern the light and current confinement ring aperture's width. For example, the width in narrower section may vary (e.g., between 0 and < ring's width $l$).

The additional reflections at the width steps along the ring diameter may allow for selecting the mode that matches the periodic pattern, while increasing the diffraction for the modes that are not correctly aligned. With this approach the layer that confines the light and the current may also act as a mode selector, yielding the excited optical mode schematically represented in the mode map 802. The benefit is improving side mode suppression ratio and single mode selection.

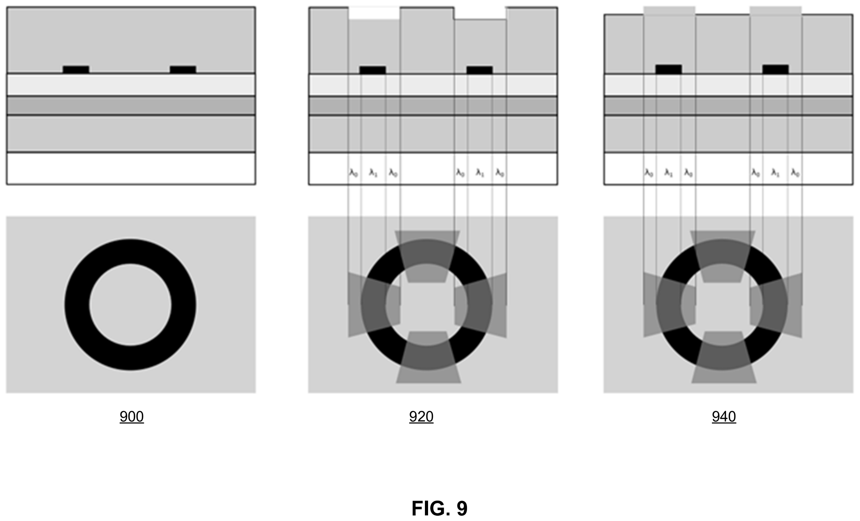

Alternatively, or additionally, in some design a periodic surface relief may be patterned on the top surface (e.g., the top surface of the top layer 360) to change the reflectivity of the epitaxially grown stack and modulate the optical losses of the structure along the ring. Depending on the initial thickness of the top layer (e.g., the top layer 360), the depth of the etch may determine the magnitude of the increase or decrease of the losses. The etching may be done either inside the surface relief regions or outside the surface relief regions. In this regard, the cross-section of the epitaxial structure in the case where the top layer (e.g., the top layer 360) may be etched inside the surface relief regions or may be etched outside of the surface relief regions. This is illustrated and described in more detail with respect to Fig. 9.

Illustrated in the aperture structure 820 is use of (only) patterning of an angularly periodic surface relief where the relief is configured to repeat at regular angular intervals around the aperture to match the one specific high order mode supported by the ring structure, without periodically patterning the light and current confinement ring aperture's width. The aperture structure 820 yields the excited optical mode schematically represented in the mode map 822. Nonetheless, the shape and the number of the individual surface relief feature may be arbitrary and is not limited to the particular patterning and surface relief illustrated in the aperture structure 820. This may also include the case where the number of the surface relief features is not the same as the number of lobes of the matching mode. With this approach the imaginary part of the effective refractive index of the structure may be affected with almost no effects on the real part. The latter is only modulated through the removal of layer 350.

The aperture structure 840 shows the case where both are modulated, combining the two approaches-that is, combining periodically patterning the light and current confinement ring aperture's width and patterning of an angularly periodic surface relief where the relief is configured to repeat at regular angular intervals around the aperture. The aperture structure 840 yields the excited optical mode schematically represented in the mode map 842.

Fig. 9 illustrates different example ring apertures with different surface etching. Shown in Fig. 9 are an aperture structure 900, an aperture structure 920, and an aperture structure 940.

Shown in Fig. 9 are various alternative approaches for facilitating use of periodic surface relief in ring apertures implemented in accordance with the present disclosure. As illustrated in Fig. 9, the aperture structure 900 comprises ring aperture without any surface relief, the aperture structure 920 comprises ring aperture with periodic surface relief where the top surface (e.g., top surface of top layer 360) is etched inside of the angularly periodic surface relief, to facilitate the periodic surface relief, and the aperture structure 940 comprises ring aperture with periodic surface relief where the top surface (e.g., top surface of top layer 360) is etched outside of the angularly periodic surface relief, to facilitate the periodic surface relief.

In this regard, shown in Fig. 9 are cross-sections of the epitaxial structure, where the top layer (e.g., the top layer 360) is not etched (the aperture structure 900), where the top layer is etched inside the surface relief regions (the aperture structure 920), and where the top layer is etched outside of the surface relief regions (the aperture structure 940).

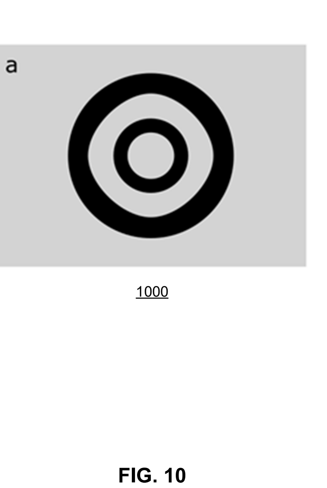

Fig. 10 illustrates an example aperture with multiple concentric rings. Shown in Fig. 10 is an aperture structure 1000, which is configured for use in a VCSEL to provide improved mode performance, as described herein.

In this regard, in some embodiments, VCSELs may be implemented with multiple concentric apertures, with each aperture being implemented in accordance with the present disclosure-that is, each of the apertures being modified to provide improved mode performance, as described herein. The concentric apertures may be arranged such that the overlap of the optical modes of multiple concentric apertures may be strongly increased. For example, VCSELs may incorporate multiple concentric ring apertures.

This is illustrated in Fig 10, with the aperture structure 1000 incorporating two concentric ring apertures. In this regard, the coupling between the two concentric ring apertures may be enhanced with respect to transverse coupled cavities due to the higher overlap of the modes of each ring aperture. As such, the overlap of the optical modes of two concentric ring apertures may be strongly increased. In this regard, the mode overlap in concentric rings may be stronger with respect to a transverse coupled cavity. This is possible because in implementations based on the present disclosure, the distance between the rings may be smaller (e.g., as small as 200 nm), which is smaller than may be possible with any existing conventional solutions.

In an example embodiment, a VCSEL is implemented where the optical mode and the current confinement is defined by patterning the same layer of the resonant cavity within the epitaxial layer with a ring shape where the ring width is small enough to be single mode along the radius. The two concentric boundaries forming the ring aperture may be of any arbitrary shape as long as the width is small enough to be single mode along the radial direction.

In an example embodiment, a single mode ring aperture VCSEL is implemented where it is possible to select one specific high angular order mode, whose power can be scaled with the area.

In an example embodiment, a ring aperture VCSEL where a periodic pattern of the patterned width is used to obtain single mode emission

In an example embodiment, a VCSEL may incorporate a ring aperture comprising a surface relief pattern that is angularly periodic, where the relief is configured to repeat at regular angular intervals around the aperture. The single surface relief feature can be of any arbitrary shape.

In an example embodiment, a VCSEL may incorporate a ring aperture where the aperture width is patterned and a periodic surface relief is etched to obtain single mode emission.

In an example embodiment, a VCSEL may incorporate multiple (22) concentric ring apertures, each of which incorporating any of the features described herein with respect to any ring aperture, that are coupled together.

An example optical device, in accordance with the present disclosure, comprises an optical source based structure, a hollow aperture disposed on top of the optical source based structure, and a top layer disposed on top of the hollow aperture, where the hollow aperture provides both current and light confinement, where the top layer is a uniform layer at least in thickness, and where the top layer covers at least the hollow aperture and hollowed areas within the hollow aperture.

In an example embodiment, the hollow aperture is patterned and the top layer is not patterned.

In an example embodiment, the hollow aperture comprises patterning features.

In an example embodiment, the patterning features comprise periodically patterned width features.

In an example embodiment, the top layer comprises surface features.

In an example embodiment, the surface features comprise one or more periodic surface relief features.

In an example embodiment, the surface features correspond to and/or correlate to patterning features in the hollow aperture.

In an example embodiment, the hollow aperture comprises a ring-shaped aperture.

In an example embodiment, the ring-shaped aperture has a uniform or circular ring shape.

In an example embodiment, the ring-shaped aperture has a non-uniform ring shape.

In an example embodiment, the non-uniform ring shape comprises elliptical or arbitrary shape.

In an example embodiment, the optical source based structure comprises a vertical-cavity surface-emitting laser (VCSEL) based structure.

In an example embodiment, the VCSEL based structure comprises a plurality of layers comprising at least a substrate layer at bottom of the VCSEL based structure, a bottom distributed Bragg-reflection (DBR) mirror layer disposed on top of the substrate layer, a cavity layer disposed on top of the bottom DBR mirror layer, where the cavity layer comprises an active region, and a top DBR mirror layer disposed on top of the cavity layer, where the plurality of layers is grown epitaxially, layer-by-layer.

An example method, in accordance with the present disclosure, comprises forming an optical device structure that comprises an optical source based structure, a hollow aperture disposed on top of the optical source based structure, and a top layer disposed on top of the hollow aperture, where the optical device structure is formed layer-by-layer using epitaxial growth, where the hollow aperture is formed such that it provides both current and light confinement, where the top layer is a uniform layer at least in thickness, and where the top layer covers at least the hollow aperture and hollowed areas within the hollow aperture.

In an example embodiment, the method further comprises forming the hollow aperture and the top layer such that the hollow aperture is patterned and the top layer is not patterned.

In an example embodiment, the method further comprises forming the hollow aperture such that the hollow aperture comprises patterning features.

In an example embodiment, the patterning features comprise periodically patterned width features.

In an example embodiment, the method further comprises the top layer such that the top layer comprises surface features.

In an example embodiment, the surface features comprise one or more periodic surface relief features.

In an example embodiment, the surface features correspond to and/or correlate to patterning features in the hollow aperture.

In an example embodiment, the method further comprises forming the hollow aperture such that the hollow aperture comprises a ring-shaped aperture.

In an example embodiment, the method further comprises forming the hollow aperture such that the ring-shaped aperture has a uniform or circular ring shape.

In an example embodiment, the method further comprises forming the hollow aperture such that the ring-shaped aperture has a non-uniform ring shape.

In an example embodiment, the non-uniform ring shape comprises elliptical or arbitrary shape.

In an example embodiment, the optical source based structure comprises a vertical-cavity surface-emitting laser (VCSEL) based structure, where forming the VCSEL based structure comprises forming a substrate layer at bottom of the VCSEL based structure, forming a bottom distributed Bragg-reflection (DBR) mirror layer on top of the substrate layer, forming a cavity layer on top of the bottom DBR mirror layer, wherein the cavity layer comprises an active region, and forming a top DBR mirror layer on top of the cavity layer, where the plurality of layers are formed layer-by-layer using epitaxial growth.

As utilized herein, "and/or" means any one or more of the items in the list joined by "and/or". As an example, "x and/or y" means any element of the three-element set $\{(x), (y), (x, y)\}$. In other words, "x and/or y" means "one or both of x and y." As another example, "x, y, and/or z" means any element of the seven-element set $\{(x), (y), (z), (x, y), (x, z), (y, z), (x, y, z)\}$. In other words, "x, y and/or z" means "one or more of x, y, and z." As utilized herein, the term "exemplary" means serving as a non-limiting example, instance, or illustration. As utilized herein, the terms "for example" and "e.g." set off lists of one or more non-limiting examples, instances, or illustrations.

As utilized herein the terms "circuits" and "circuitry" refer to physical electronic components (e.g., hardware), and any software and/or firmware ("code") that may configure the hardware, be executed by the hardware, and or otherwise be associated with the hardware. As used herein, for example, a particular processor and memory (e.g., a volatile or non-volatile memory device, a general computer-readable medium, etc.) may comprise a first "circuit" when executing a first one or more lines of code and may comprise a second "circuit" when executing a second one or more lines of code. Additionally, a circuit may comprise analog and/or digital circuitry. Such circuitry may, for example, operate on analog and/or digital signals. It should be understood that a circuit may be in a single device or chip, on a single motherboard, in a single chassis, in a plurality of enclosures at a single geographical location, in a plurality of enclosures distributed over a plurality of geographical locations, etc. Similarly, the term "module" may, for example, refer to a physical electronic components (e.g., hardware) and any software and/or firmware ("code") that may configure the hardware, be executed by the hardware, and or otherwise be associated with the hardware.

As utilized herein, circuitry or module is "operable" to perform a function whenever the circuitry or module comprises the necessary hardware and code (if any is necessary) to perform the function, regardless of whether performance of the function is disabled or not enabled (e.g., by a user-configurable setting, factory trim, etc.).

Other embodiments of the invention may provide a non-transitory computer readable medium and/or storage medium, and/or a non-transitory machine readable medium and/or storage medium, having stored thereon, a machine code and/or a computer program having at least one code section executable by a machine and/or a computer, thereby causing the machine and/or computer to perform the processes as described herein.

Various embodiments in accordance with the present invention may also be embedded in a computer program product, which comprises all the features enabling the implementation of the methods described herein, and which when loaded in a computer system is able to carry out these methods. Computer program in the present context means any expression, in any language, code or notation, of a set of instructions intended to cause a system having an information processing capability to perform a particular function either directly or after either or both of the following: a) conversion to another language, code or notation; b) reproduction in a different material form.

This disclosure may relate to the following implementations: Systems and methods are provided for ring aperture vertical-cavity surface-emitting laser (VCSEL) devices for mode control. A VCSEL is provided where the optical mode and the current confinement is defined by patterning the same layer of the resonant cavity within the epitaxial layer with a ring-shaped aperture. The ring width may be small enough to be single mode along the radius. The two concentric boundaries forming the ring aperture may be of any arbitrary shape as long as the width is small enough to be single mode along the radial direction.

The present application claims priority of US patent application 63/833,908 filed on January 24, 2025, and of US patent application 63/749,559 filed on January 25, 2025, and of US patent application 19/372,850 filed on October 29, 2025. The entire disclosure content of these applications is hereby incorporated herein by reference for all purposes.

In the following, a set of items is disclosed. The items are numbered to facilitate referencing the features of one item in other items. The items form part of the present disclosure and could be made subject to independent and/or dependent claims irrespective of what currently is claimed in the application. We note, however, that the scope of protection is defined by the appended claims, where the following items do not constitute claims. The items are:

    1. An optical device comprising:

> an optical source based structure;
> a hollow aperture disposed on top of the optical source based structure; and
> a top layer disposed on top of the hollow aperture;
> wherein:
>> the hollow aperture provides both current and light confinement,
>> the top layer is a uniform layer at least in thickness, and
>> the top layer covers at least the hollow aperture and hollowed areas within the hollow aperture.

    2. The optical device according to item 1, wherein the hollow aperture is patterned and the top layer is not patterned.

3. The optical device according to item 1, wherein the hollow aperture comprises patterning features.

4. The optical device according to item 3, wherein the patterning features comprise periodically patterned width features.

5. The optical device according to item 1, wherein the top layer comprises surface features.

6. The optical device according to item 5, wherein the surface features comprise one or more periodic surface relief features.

7. The optical device according to item 5, wherein the surface features correspond to and/or correlate to patterning features in the hollow aperture.

8. The optical device according to item 1, wherein the hollow aperture comprises a ring-shaped aperture.

9. The optical device according to item 8, wherein the ring-shaped aperture has a uniform or circular ring shape.

10. The optical device according to item 8, wherein the ring-shaped aperture has a non-uniform ring shape.

11. The optical device according to item 10, wherein the non-uniform ring shape comprises elliptical or arbitrary shape.

12. The optical device according to item 1, wherein the optical source based structure comprises a vertical-cavity surface-emitting laser (VCSEL) based structure.

13. The optical device according to item 12, wherein the VCSEL based structure comprises a plurality of layers comprising, at least:

> a substrate layer at bottom of the VCSEL based structure;
> a bottom distributed Bragg-reflection (DBR) mirror layer disposed on top of the substrate layer;
> a cavity layer disposed on top of the bottom DBR mirror layer, wherein the cavity layer comprises an active region; and
> a top DBR mirror layer disposed on top of the cavity layer;
> wherein the plurality of layers is grown epitaxially.

14. A method comprising:

forming an optical device structure that comprises an optical source based structure, a hollow aperture disposed on top of the optical source based structure, and a top layer disposed on top of the hollow aperture;

wherein the optical device structure is formed layer-by-layer using epitaxial growth,

wherein the hollow aperture is formed such that it provides both current and light confinement,

wherein the top layer is a uniform layer at least in thickness, and

wherein the top layer covers at least the hollow aperture and hollowed areas within the hollow aperture.

15. The method according to item 14, further comprising forming the hollow aperture and the top layer such that the hollow aperture is patterned and the top layer is not patterned.

16. The method according to item 14, further comprising forming the hollow aperture such that the hollow aperture comprises patterning features.

17. The method according to item 16, wherein the patterning features comprise periodically patterned width features.

18. The method according to item 14, further comprising the top layer such that the top layer comprises surface features.

19. The method according to item 18, wherein the surface features comprise one or more periodic surface relief features.

20. The method according to item 18, wherein the surface features correspond to and/or correlate to patterning features in the hollow aperture.

21. The method according to item 14, further comprising forming the hollow aperture such that the hollow aperture comprises a ring-shaped aperture.

22. The method according to item 21, further comprising forming the hollow aperture such that the ring-shaped aperture has a uniform or circular ring shape.

23. The method according to item 21, further comprising forming the hollow aperture such that the ring-shaped aperture has a non-uniform ring shape.

24. The method according to item 23, wherein the non-uniform ring shape comprises elliptical or arbitrary shape.

25. The method according to item 14, wherein the optical source based structure comprises a vertical-cavity surface-emitting laser (VCSEL) based structure, and wherein forming the VCSEL based structure comprises:

forming a substrate layer at bottom of the VCSEL based structure;

forming a bottom distributed Bragg-reflection (DBR) mirror layer on top of the substrate layer;

forming a cavity layer on top of the bottom DBR mirror layer, wherein the cavity layer comprises an active region; and

forming a top DBR mirror layer on top of the cavity layer;

wherein the plurality of layers are formed layer-by-layer using epitaxial growth.

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

**Claims**

1. An optical device comprising:

an optical source based structure;
a hollow aperture disposed on top of the optical source based structure; and
a top layer disposed on top of the hollow aperture;
wherein:

the hollow aperture provides both current and light confinement,
the top layer is a uniform layer at least in thickness, and
the top layer covers at least the hollow aperture and hollowed areas within the hollow aperture.

2. The optical device according to claim 1, wherein the hollow aperture is patterned and the top layer is not patterned.

3. The optical device according to any one of the preceding claims, wherein the hollow aperture comprises patterning features.

**4.** The optical device according to claim 3, wherein the patterning features comprise periodically patterned width features.

**5.** The optical device according to any one of the preceding claims, wherein the top layer comprises surface features.

**6.** The optical device according to claim 5, wherein

a) the surface features comprise one or more periodic surface relief features, and/or
b) the surface features correspond to and/or correlate to patterning features in the hollow aperture.

**7.** The optical device according to any one of the preceding claims, wherein the hollow aperture comprises a ring-shaped aperture, wherein, optionally,

a) the ring-shaped aperture has a uniform or circular ring shape, or
b) the ring-shaped aperture has a non-uniform ring shape, wherein, optionally,

the non-uniform ring shape comprises elliptical or arbitrary shape.

**8.** The optical device according to any one of the preceding claims, wherein the optical source based structure comprises a vertical-cavity surface-emitting laser (VCSEL) based structure.

**9.** The optical device according to claim 8, wherein the VCSEL based structure comprises a plurality of layers comprising, at least:

a substrate layer at bottom of the VCSEL based structure;
a bottom distributed Bragg-reflection (DBR) mirror layer disposed on top of the substrate layer;
a cavity layer disposed on top of the bottom DBR mirror layer, wherein the cavity layer comprises an active region; and
a top DBR mirror layer disposed on top of the cavity layer;
wherein the plurality of layers is grown epitaxially.

**10.** A method comprising:

forming an optical device structure that comprises an optical source based structure, a hollow aperture disposed on top of the optical source based structure, and a top layer disposed on top of the hollow aperture;
wherein the optical device structure is formed layer-by-layer using epitaxial growth,

wherein the hollow aperture is formed such that it provides both current and light confinement, wherein the top layer is a uniform layer at least in thickness, and
wherein the top layer covers at least the hollow aperture and hollowed areas within the hollow aperture.

**11.** The method according to claim 10, further comprising

a) forming the hollow aperture and the top layer such that the hollow aperture is patterned and the top layer is not patterned, and/or
b) forming the hollow aperture such that the hollow aperture comprises patterning features, wherein, optionally, the patterning features comprise periodically patterned width features.

**12.** The method according to claim 10 or 11, further comprising forming the top layer such that the top layer comprises surface features, wherein, optionally,

a) the surface features comprise one or more periodic surface relief features, and/or wherein, optionally,
b) the surface features correspond to and/or correlate to patterning features in the hollow aperture.

**13.** The method according to any one of claims 10 to 12, further comprising forming the hollow aperture such that the hollow aperture comprises a ring-shaped aperture, wherein the method, optionally, further comprises

a) forming the hollow aperture such that the ring-shaped aperture has a uniform or circular ring shape, or
b) forming the hollow aperture such that the ring-shaped aperture has a non-uniform ring shape.

**14.** The method according to claim 13, option b), wherein the non-uniform ring shape comprises elliptical or arbitrary shape.

**15.** The method according to any one of claims 10 to 14, wherein the optical source based structure comprises a vertical-cavity surface-emitting laser (VCSEL) based structure, and wherein forming the VCSEL based structure comprises:

forming a substrate layer at bottom of the VCSEL based structure;
forming a bottom distributed Bragg-reflection (DBR) mirror layer on top of the substrate layer;
forming a cavity layer on top of the bottom DBR mirror layer, wherein the cavity layer comprises an active region; and
forming a top DBR mirror layer on top of the cavity layer;
wherein the plurality of layers are formed layer-by-layer using epitaxial growth.

110

120

130

140

150

100

FIG. 1

FIG. 2

EP 4 783 380 A1

FIG. 3

FIG. 4

500

EP 4 783 380 A1

**FIG. 5**

**Aperture patternig**

**Excited optical modes**

a 602  b 604  c 606  d 608

600

e 622  f 624  g 626  h 628

620

**FIG. 6**

c
740

b
720

a
700

**FIG. 7**

FIG. 8

900 920 940

**FIG. 9**

FIG. 10

Europäisches
Patentamt

European
Patent Office

Office européen
des brevets

# EUROPEAN SEARCH REPORT

**Application Number**

EP 25 22 3311

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 396 865 B1 (MAWST LUKE J [US] ET AL) 28 May 2002 (2002-05-28) | 1,5-10, 12-15 | INV. H01S5/183 |
| Y | * column 4, line 27 - column 7, line 9; figures 1-7,13 * | 14 | |
| X | TSAI CHIA-LUNG ET AL: "SiOx-planarized and transistor outlook-packaged oxide-confined vertical-cavity surface-emitting lasers with ring-shape geometry for high-speed (10Gb/s) operation", JOURNAL OF VACUUM SCIENCE AND TECHNOLOGY: PART B. AVS / AIP, MELVILLE, NEW YORK, NY., US, vol. 27, no. 1, 27 January 2009 (2009-01-27), pages 156-160, XP012129044, ISSN: 1071-1023, DOI: 10.1116/1.3072514 [retrieved on 2009-01-27] | 1-3, 7-11, 13-15 | |
| Y | * page 157, left-hand column, paragraph 3 - page 157, right-hand column, paragraph 1; figure 1 * | 14 | TECHNICAL FIELDS SEARCHED (IPC) |
| X | US 2021/351568 A1 (KURAMOTO MASARU [JP]) 11 November 2021 (2021-11-11) | 1-9 | H01S |
| Y | * paragraphs [0024] - [0105]; figures 1-10 * | 14 | |
| X | US 2022/140570 A1 (KURAMOTO MASARU [JP] ET AL) 5 May 2022 (2022-05-05) * paragraphs [0026] - [0083]; figures 1-7 * | 1-4,7-9 | |
| X | US 2005/147143 A1 (JIKUTANI NAOTO [JP]) 7 July 2005 (2005-07-07) * paragraphs [0382] - [0480]; figures 1-11 * | 1,2,7-9 | |

The present search report has been drawn up for all claims

| Place of search | Date of completion of the search | Examiner |
|---|---|---|
| Munich | 19 May 2026 | Laenen, Robert |

EPO FORM 1503 03.82 (P04C01)

## ANNEX TO THE EUROPEAN SEARCH REPORT
## ON EUROPEAN PATENT APPLICATION NO.

EP 25 22 3311

This annex lists the patent family members relating to the patent documents cited in the above-mentioned European search report.
The members are as contained in the European Patent Office EDP file on
The European Patent Office is in no way liable for these particulars which are merely given for the purpose of information.

19-05-2026

| Patent document cited in search report | | Publication date | Patent family member(s) | | Publication date |
|---|---|---|---|---|---|
| US 6396865 | B1 | 28-05-2002 | NONE | | |
| US 2021351568 | A1 | 11-11-2021 | CN | 112913094 A | 04-06-2021 |
| | | | EP | 3869643 A1 | 25-08-2021 |
| | | | JP | 7190865 B2 | 16-12-2022 |
| | | | JP | 2020064993 A | 23-04-2020 |
| | | | US | 2021351568 A1 | 11-11-2021 |
| | | | US | 2025266663 A1 | 21-08-2025 |
| | | | WO | 2020080160 A1 | 23-04-2020 |
| US 2022140570 | A1 | 05-05-2022 | CN | 113454860 A | 28-09-2021 |
| | | | EP | 3930122 A1 | 29-12-2021 |
| | | | JP | 7291497 B2 | 15-06-2023 |
| | | | JP | 2020136524 A | 31-08-2020 |
| | | | US | 2022140570 A1 | 05-05-2022 |
| | | | WO | 2020170818 A1 | 27-08-2020 |
| US 2005147143 | A1 | 07-07-2005 | US | 2005147143 A1 | 07-07-2005 |
| | | | US | 2009268769 A1 | 29-10-2009 |

EPO FORM P0459

For more details about this annex : see Official Journal of the European Patent Office, No. 12/82

**REFERENCES CITED IN THE DESCRIPTION**

**Patent documents cited in the description**

- US 63833908
- US 63749559

- US 37285025